# EUROPEAN PATENT APPLICATION

(11) **EP 2 685 509 A1**
(43) Date of publication of application: **15.01.2014**
(21) Application number: 13167189.3
(22) Date of filing: 09.05.2013
(51) Int. Cl.: H01L 31/042

(54) **Connecting structure of solar cell modules**

(30) Priority: 12.07.2012 US 201261670975 P; 14.03.2013 US 201313831097
(71) Applicant: Samsung SDI Co., Ltd., Yongin-si, Gyeonggi-do (KR)
(72) Inventor: Song, Nam-Kyu, Gyeonggi-do (KR); Kim, Jong-Hwan, Gyeonggi-do (KR); Park, Yong-Hee, Gyeonggi-do (KR); Jung, June-Hyuk, Gangnam-gu, Seoul 135-971 (KR)
(74) Representative: Mounteney, Simon James

(57) **Abstract**

The present invention relates to connecting structures of solar cell modules, particularly, to connecting structures of solar cell modules in which connection between solar cell modules and alignment of the solar cell modules may be easily performed.

## Description

### [Detailed Description of the Invention]

### [Technical Field]

One or more embodiments of the present invention relate to connecting structures of solar cell modules, particularly, to connecting structures of solar cell modules in which connection between solar cell modules and alignment of the solar cell modules may be easily performed.

### [Related Art]

Recently, as the exhaustion of energy sources such as oil or coal is expected, interests in substitute energy are increasing. Among others, solar cells are batteries that convert solar energy directly into electrical energy by using a semiconductor device and are regarded as a next-generation battery.

A solar cell converts light energy into electrical energy by using the photovoltaic effect, and may be classified according to materials, for example, into a silicon solar cell, a thin film solar cell, a dye-sensitized solar cell, and an organic polymer solar cell.

A solar generator includes an array formed by connecting a plurality of solar cell modules in which solar cells are connected serially or in parallel. According to the conventional art, screw holes are processed in frames of the solar cell modules, and, for example, a connection plate in which assembly holes of the screw holes are formed, are disposed between adjacent solar cell modules, and the plurality of solar cell modules are connected by screw assembling, by which the assembly holes and the screw holes are coupled, to form an array. However, according to this method, it is difficult to form the screw holes, and if the screw holes and the assembly holes do not match up with each other, it is difficult to align the plurality of solar cell modules with one another.

### [Disclosure of the Invention]

### [Technical Goal of the Invention]

One or more embodiments of the present invention include a connecting structure of solar cell modules in which connection of the solar cell modules and alignment of the solar cell modules may be easily performed.

### [Means for Achieving Technical Goal]

### [Effect of the Invention]

According to the embodiments of the present invention, solar cell modules may be easily connected and aligned.

### [Brief Description of the Drawings]

FIG. 1 is a schematic view of a connecting structure of solar cell modules according to an embodiment of the present invention;
FIG. 2 is an exploded perspective view of a solar cell unit of FIG. 1;
FIG. 3 illustrates a connection member illustrated in FIG. 1;
FIG. 4 is a cross-sectional view the of solar cell unit of FIG. 1 cut along a line I-I';
FIGS. 5A through 5C illustrate a method of connecting solar cell modules using the connecting structure of FIG. 1;
FIG. 6 is a modification example of a connecting structure of solar cell modules of FIG. 1; and
FIG. 7 is another modification example of a connecting structure of solar cell modules of FIG. 1.
FIG. 8 illustrates a connection member of the present invention;
FIG. 9 is a modification example of a connecting structure of solar cell modules of FIG. 8
FIG. 10 illustrates a connection member of the present invention;
FIG. 11 illustrates a connection member of the present invention;
FIG. 12 is a modification example of a connecting structure of a connection member of the present invention.

**[Explanation of Selected Reference Numerals]**

| | | | |
|---|---|---|---|
| 1: | first solar cell module | 2: | second solar cell module |
| 100: | solar cell unit | 200: | frame |
| 211: | first insertion hole | 212: | second insertion hole |
| 220: | receiving portion | 222: | guide portion |
| 300: | connection member | 310: | connection portion |
| 320: | coupling portion | | |

### [Description of Embodiment]

In the drawings, each constituent element is exaggerated, omitted, or schematically illustrated for convenience of explanation and clarity. Also, the size of each constituent element does not perfectly reflect an actual size. In the present specification, when each constituent element is described as being formed "on" or "under" a constituent element, the constituent element may be formed "directly" or "indirectly" with any other constituent element interposed therebetween "on" or "under" the constituent element. The status of "on" or "under" of a constituent element is described based on the drawings. In addition, like elements are labelled with like reference numerals even when illustrated in different drawings.

The present invention provides a solar cell module array comprising:
a first solar cell module (1);
a second solar cell module (2); and
a connection member (300) for connecting the first solar cell module (1) to the second solar cell module (2); wherein
the first solar cell module (1) comprises a first insertion hole (211);
the second solar cell module (2) comprises a second insertion hole (212); and
the connection member (300) comprises a first coupling portion (320) adapted to be received within a receiving portion (220) of the first insertion hole (211) and a second coupling portion (320) adapted to be received within a receiving portion (220) of the second insertion hole (212), the said first and second coupling portions (320) being connected by a connection portion (310) of the connection member (300);
characterised in that at least one of the receiving portions (220) comprises a respective guide portion (222) having a respective concave surface, the said concave surface being curved about an axis extending substantially perpendicular to an insertion direction in which the connection member (300) may be inserted into the insertion holes (211, 212).

In an embodiment of the present invention provided is a solar cell module array, wherein the said concave surface is partly circular in cross-section. In a preferred embodiment the partly circular cross-section is across an axis extending substantially perpendicular to an insertion direction and an axis along said insertion direction, preferably the cross-section is across axes x and z discussed below. In an embodiment of the present invention the term partly-circular is preferably an arc of a circle from 75° to 180°, preferably 90° to 180°, more preferably 125° to 180°, more preferably 140° to 180°. In an embodiment of the present invention the partly circular cross section is substantially hemi-circular.

In an embodiment of the present invention the said concave surface is partly spherical. In this embodiment of the present invention, the term partly spherical preferably means that the concave surface would cover 25% to 55% of a sphere of the same radius as the receiving portion, preferably 35% to 55%, more preferably 40% to 50%.

In an embodiment of the present invention the said concave surface is partly cylindrical. In this embodiment of the present invention, the term partly cylindrical preferably means that the concave surface would cover 25% to 55% of a cylinder of the same radius and width as the receiving portion, preferably 35% to 55%, more preferably 40% to 50%.

In an embodiment of the present invention all of the receiving portions have the same shape.

In an embodiment of the present invention provided is a solar cell module array, wherein at least one of the coupling portions (320) comprises a respective convex surface adapted to bear against a respective said concave surface when the coupling portion (320) is received with the receiving portion (220).

In a preferred embodiment of the present invention all of the coupling portions have the same shape.

In an embodiment of the present invention provided is a solar cell module array, wherein the said convex surface is partly circular in cross-section. In a preferred embodiment the partly circular cross-section is across an axis extending substantially perpendicular to an insertion direction and an axis along said insertion direction, preferably the cross-section is across axes x and z discussed below. In an embodiment of the present invention the partly circular cross section is substantially hemi-circular, for example, hemi-circular (320, 820, 920, 1020) or hemi-circular with a flange (1020 and 1020a). In respect of the embodiment where the cross section is hemi-circular with a flange, the partly-circular portion is preferably an arc of a circle from 100° to 175°, more preferably 125° to 170°, more preferably 150° to 165°, and the flange makes up the rest of the cross-section.

In a preferred embodiment of the present invention at least one of the coupling portions has a cross section across the two other axes perpendicular, preferably the cross-section is across axes y and z discussed below, to an axis along an insertion direction selected from the group consisting of square, rectangular (820, 920, 1020), a truncated part-circle (320) or a convex pentalateral (1120). In an embodiment of the present invention the term "truncated part-circle" in respect of this cross-section is preferably an arc of a circle from 25° to 180°, preferably 75° to 180°, more preferably 125° to 180°, more preferably 145° to 175°, more preferably 150° to 165°. In a preferred embodiment the truncated part-circle cross section comprises two flat portions.

In an embodiment of the present invention at least of one of the coupling portions has a shape selected from the group consisting of a partly hemi-sphere (320), a segment of a hemi-cylinder (820, 920), or a segment of a hemi-cylinder with a flange (1020, 1020a). In a preferred embodiment the partly hemi-spherical shape is a truncated sphere comprising a flat surface. In an embodiment of the present invention, the term "partly hemi-spherical" preferably means that the convex surface is 25% to 50% of the surface of a sphere of the same radius as the coupling portion, preferably 30% to 45%, more preferably 35% to 40%.

In an embodiment of the present invention the connection member includes further coupling portions, for example the connection member may include between 2 and 10 coupling portions, preferably between 2 and 6 coupling portions. For example, the connection member may include 2 or 4 coupling portions.

In an embodiment of the present invention the connection member (300) is substantially dumbbell-shaped.

In an embodiment of the present invention the connection portion (310) a cross-section across an axis extending substantially perpendicular to an insertion direction and an axis along said insertion direction of the connection portion (310) may be rectangular, circular, or hemisphere-shaped. In an embodiment of the present invention the connection portion (310) is in the shape of a rod.

In an embodiment of the present invention the connecting member has a flat surface that is coplanar with a flat surface of at least one of the coupling portions.

In an embodiment of the present invention the concave surface and the convex surface have the same radius. In a preferred embodiment the radius is measured along the direction of insertion.

In an embodiment of the present invention the at least one of the receiving portions (220) comprises a respective return surface (224) facing in the opposite direction to the insertion direction and adapted to act as a seat for a respective one of the coupling portions (320).

In an embodiment of the present invention the at least one of the receiving portions (220) comprises a first locking formation (226) and at least one of the coupling portions (320) comprises a second locking formation (330), the said first and second locking formations (226, 330) being adapted to cooperate to secure the coupling portion (320) within the receiving portion (220).

In an embodiment of the present invention one of the first and second locking formations (226, 330) is a projection (226) and the other of the first and second locking formations (226, 330) is a recess (330). In a preferred embodiment the first locking formation is a barb (226).

In an embodiment of the present invention the connection portion (310) is an elongate member.

In an embodiment of the present invention the at least one of the insertion holes (211, 212) comprises a plurality of said receiving portions (220A, 220B, 220C) spaced from each other in the said insertion direction.

In an embodiment of the present invention the solar cell module comprises a plurality of said connection members (300).

In an embodiment the present invention provides a solar cell module array wherein the first solar cell module (1) comprises a first solar cell unit (100) surrounded by a first frame (200) and the second solar cell module (2) comprises a second solar cell unit (100) surrounded by a second frame (200); the first insertion hole (211) being provided in the first frame (200) and the second insertion hole(212) being provided in the second frame (200).

The present invention will now be described more fully with reference to the accompanying drawings, in which embodiments of the invention are shown.

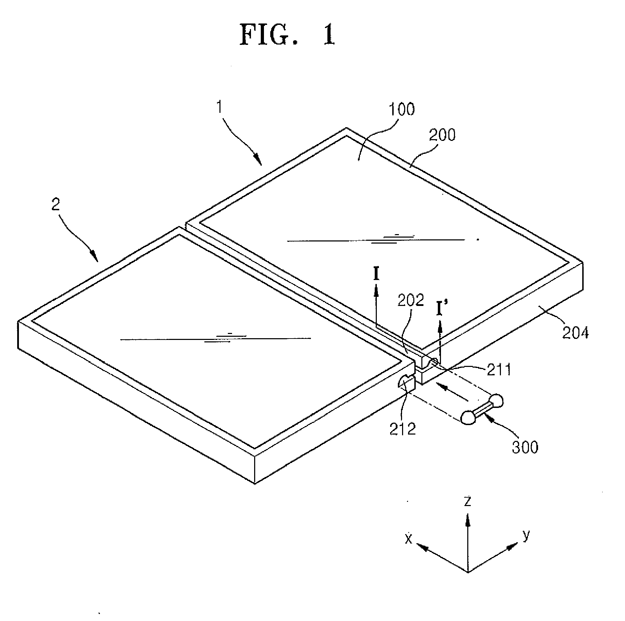

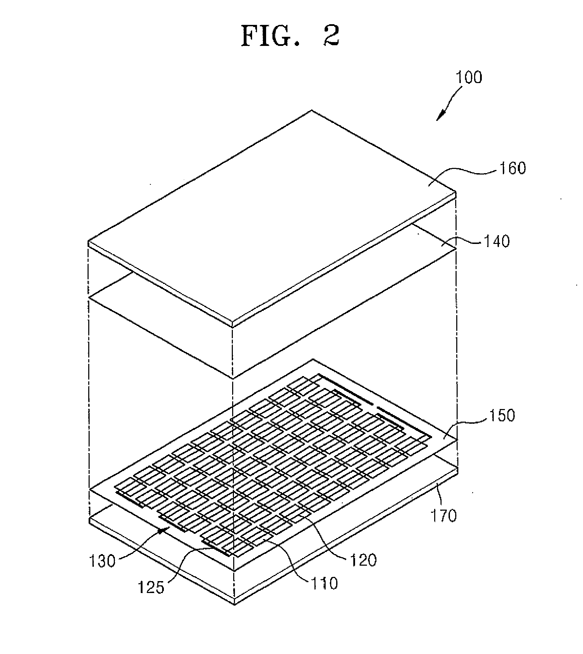

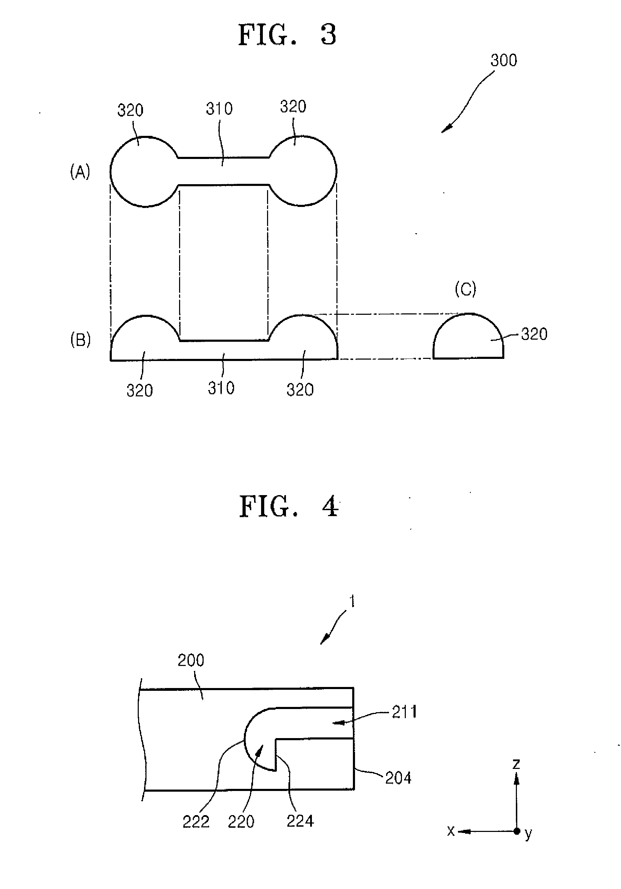

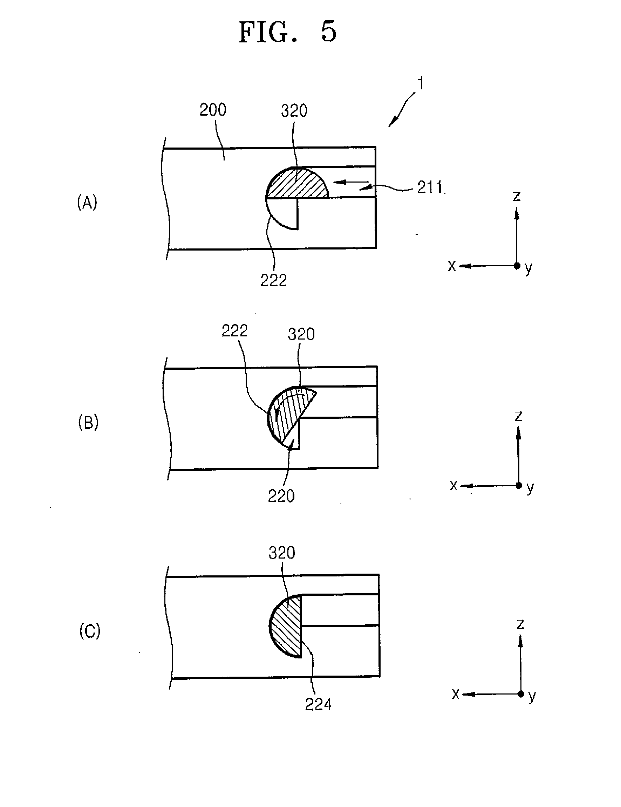

FIG. 1 is a schematic view of a connecting structure of solar cell modules according to an embodiment of the present invention. FIG. 2 is an exploded perspective view of a solar cell unit 100 of FIG. 1. FIG. 3 illustrates a connection member 300 illustrated in FIG. 1. FIG. 4 is a cross-sectional view of the solar cell unit 100 of FIG. 1 cut along a line I-I'. FIGS. 5A through 5C illustrate a method of connecting solar cell modules using the connecting structure of FIG. 1.

Referring to FIG. 1, in the connecting structure of solar cell modules, a first solar cell module 1 and a second solar cell module 2 which are disposed adjacent to each other are connected. The first solar cell module 1 and the second solar cell module 2 may be connected by inserting a connection member 300 into each of a first insertion hole 211 formed in the first solar cell module 1 and a second insertion hole 212 formed in the second solar cell module 2.

First, the first solar cell module 1 and the second solar cell module 2 may have the same, rectangular shape, and then placed on holder (not shown) or the like and connected to one another to form an array.

Each of the first solar cell module 1 and the second solar cell module 2 includes a solar cell unit 100 and a frame 200 connected to a boundary of the solar cell unit 100. As the first solar cell module 1 and the second solar cell module 2 have the same shape, description will focus on the first solar cell module 1 below. Also, the first solar cell module 1 will be described with respect to a first direction x, a second direction y that is perpendicular to the first direction x, and a third direction z that is perpendicular to the first direction x and the second direction y. The first direction x may be a length direction of the first solar cell module 1, the second direction y may be a width direction of the first solar cell module 1, and the third direction z may be a thickness direction of the first solar cell module 1.

As illustrated in FIG. 2, the solar cell unit 100 may include a plurality of solar cells 110, a plurality of ribbons 120 that form a plurality of solar cell strings 130 by electrically connecting the plurality of solar cells 110, a first encapsulation film 140 and a front substrate 160 that are disposed above the plurality of solar cells 110, and a second encapsulation film 150 and a rear substrate 170 that are disposed below the plurality of solar cells 110.

The solar cells 110 are each a semiconductor device that converts solar energy into electrical energy, and may be, for example, a silicon solar cell, a compound semiconductor solar cell, a dye-sensitized solar cell, or a tandem solar cell.

The ribbons 120 electrically connect the plurality of solar cells 110 serially, in parallel or in combination of serial and parallel connection to form the solar cell strings 130. In detail, the ribbons 120 may connect a front electrode formed on a light receiving surface of the solar cell 110 and a rear electrode formed on a rear surface of another adjacent solar cell 110 by using a tabbing operation. The tabbing operation may be performed by coating a surface of the solar cells 110 with a flux, and disposing the ribbons 120 on the solar cells 110 coated with a flux, and heat treatment. Alternatively, a conductive film (not shown) may be attached between a surface of the solar cells 110 and the ribbons 120, and then the plurality of solar cells 110 may be connected in series or in parallel by thermal compression.

Meanwhile, each of the solar cell strings 130 may be electrically connected to one another via bus ribbons 125. In detail, the bus ribbons 125 are arranged horizontally at two ends of the solar cell strings 130, and the two ends of the ribbons 120 of the solar cell strings 130 may be alternately connected. Also, although not shown in FIG. 2, the bus ribbons 125 are connected to a junction box (not shown) which is disposed on a rear surface of the solar cell unit 100.

The first encapsulation film 140 is disposed on the light receiving surface of the solar cells 110, and the second encapsulation film 150 is disposed on a rear surface of the solar cells 110. The first encapsulation film 140 and the second encapsulation film 150 are adhered by lamination and block water or oxygen which may adversely affect the solar cells 110.

The first encapsulation film 140 and the second encapsulation film 150 may be formed of, for example, an ethylene vinyl acetate (EVA) copolymer, polyvinyl butyral, oxide of ethylene vinyl acetate, silicon resin, ester resin, or olefin resin.

The front substrate 160 is disposed on the first encapsulation film 140 and may be formed of a highly light transmissive glass or a polymer material. Also, to protect the solar cells 110 from external impact, the front substrate 160 may preferably be formed of tempered glass; more preferably, in order to prevent reflection of solar light and to increase transmittance of solar light, the front substrate 160 may be formed of low-iron tempered glass of a low iron content.

The rear substrate 170 is a layer protecting the solar cells 110 on the rear surface of the solar cell 110, and performs functions such as water proofing, insulation, and ultraviolet (UV) blocking. The rear substrate 170 may be a stacked structure of polyvinyl fluoride/PET/polyvinyl fluoride, but is not limited thereto.

While the solar cell unit 100 including the solar cells 110 that are crystalline has been described above, the solar cell unit 100 is not limited thereto, and the solar cell unit 100 may include a thin film type solar cell, a dye-sensitized solar cell, or an organic polymer type solar cell.

The frame 200 is connected to a boundary of the solar cell unit 100, and the first insertion hole 211 is formed in the frame 200.

The first insertion hole 211 may be formed in the frame 200 of the first solar cell module 1 along a first surface 202. In detail, the first insertion hole 211 is a groove that extends from the first surface 202 of the frame 200 to a predetermined depth in the second direction y of the first solar cell module 1, and passes through a second surface 204 that is vertical to the first surface 202 and is formed along the first direction x of the first solar cell module 1.

Also, a height of the first insertion hole 211 corresponds to the third direction z of the first solar cell module 1, and the first insertion hole 211 may extend along the second direction y of the first solar cell module from the first surface 202 of the frame 200 at a predetermined height and have a hemisphere shape at an internal end thereof. The shape of the first insertion hole 211 corresponds to a shape of a connection member 300 (see FIG. 3) which will be described later with reference to FIG. 3 and FIG. 8, 10 and 11. Accordingly, the insertion holes have profiles that match the cross section across axis y and axis z of the coupling portions. Accordingly, although FIG. 1 displays partly hemi-spherical cross sections, the cross section of the insertion holes is modified to match the coupling portion.

Meanwhile, the second insertion hole 212 formed in the second solar cell module 2 adjacent to the first solar cell module 1 is formed symmetrically to the first insertion hole 211 described above with respect to the first direction x of the first solar cell module 1. As the connection member 300 is inserted simultaneously both into the first insertion hole 211 and the second insertion hole 212, the first solar cell module 1 and the second solar cell module 2 may be connected to each other. Also, although not shown in the drawings, a third insertion hole (not shown) may be further formed along the second surface 204. Accordingly, the first solar cell module 1 may be connected to a third solar cell module (not shown) not only in the second direction y but also in the first direction x.

FIGS. 3A, 3B, and 3C are a plan view, a front view, and a side view of the connection member 300. Referring to FIG. 3, the connection member 300 includes two coupling portions 320 and a connection portion 310 connecting the two coupling portions 320.

The two coupling portions 320 are hemisphere-shaped, and are respectively inserted into the first insertion hole 211 and the second insertion hole 212. When the two coupling portions 320 are inserted into the first insertion hole 211 and the second insertion hole 212, the connection portion 310 may fix such that the first solar cell module 1 and the second solar cell module 2 so that they are not separated from each other. A cross-section of the connection portion 310 may be rectangular, circular, or hemisphere-shaped, but is not limited thereto.

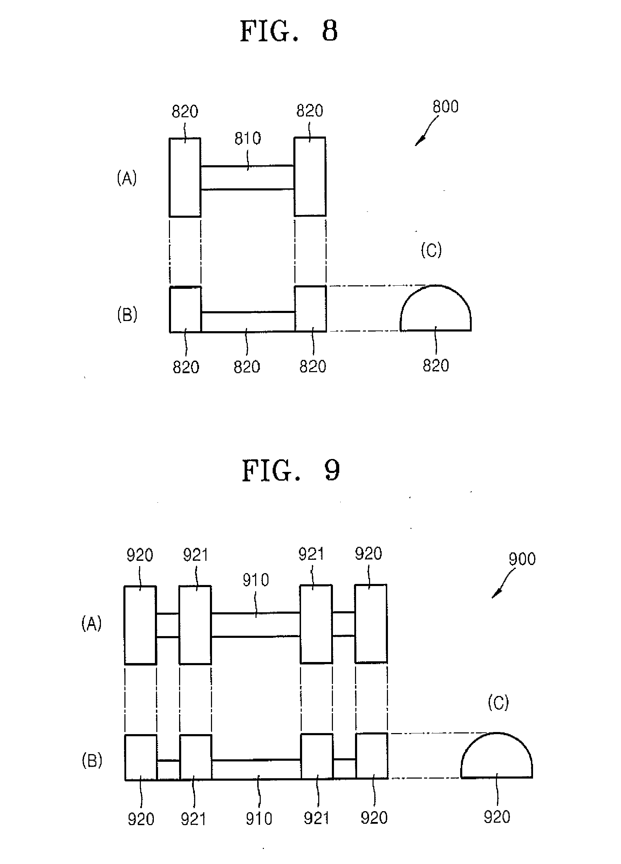

FIGS. 8A, 8B, and 8C are a plan view, a front view, and a side view of the connection member 800. Referring to FIG. 8, the connection member 800 includes two coupling portions 820 and a connection portion 810 connecting the two coupling portions 820.

The two coupling portions 820 are in the shape of a segment of a hemi-cylinder, and are respectively inserted into the first insertion hole and the second insertion hole. When the two coupling portions 820 are inserted into the first insertion hole and the second insertion hole, the connection portion 810 may fix such that the first solar cell module 1 and the second solar cell module 2 so that they are not separated from each other. A cross-section, preferably across axis x and axis z, of the connection portion 810 may be rectangular, circular, or hemisphere-shaped, but is not limited thereto.

The connection members displayed in FIGS. 9 to 11 have features corresponding to the above features recited with respect to FIG. 8 accordingly we will not discuss the identical features here, the features that differentiate the embodiments are discussed below:

in FIG. 9 connection member 900 has third 921 and fourth coupling 921 coupling portions both of which are the shape of a segment of a hemi-cylinder,

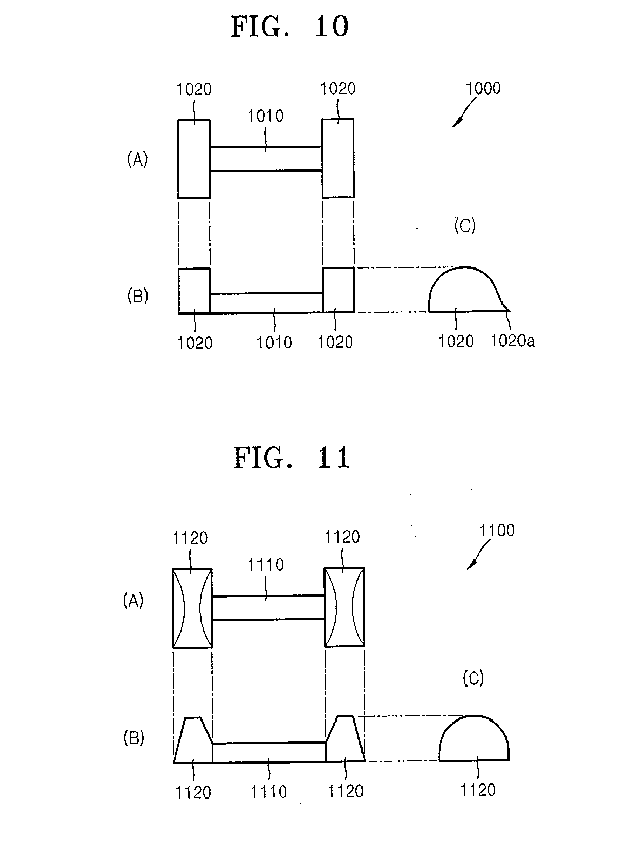

in FIG 10 connection member 1000 includes coupling portions 1020 which have a cross section across an axis extending substantially perpendicular to an insertion direction and an axis along said insertion direction (i.e. across axis x and axis z) that is hemi-circular with a flange 1020a, and

in FIG. 11 connection member 1100 includes coupling portions 1120 which have a cross section across the two other axes perpendicular to an axis along an insertion direction (i.e. across axis y and axis z) that is a tapered convex pentalateral in shape.

In an embodiment of the present invention, the flange (e.g. 1020a) is capable of fitting into corresponding section of a receiving portion and locking into place. In an embodiment of the present invention, the flange projects from the coupling portion to form a lip. In an embodiment of the present invention the flange may be triangular or quarter-circular in a cross section taken along the first direction x and third direction z. In an embodiment of the present invention, the flange is based on a triangular cross section taken along the first direction x and third direction z wherein the hypotenuse is modified to be convex or concave, e.g. a convex or concave crescented-right angle triangle. In an embodiment of the present invention the flange portion is flexible. In an embodiment of the present invention, the cross section taken along the first direction x and third direction z of the coupling portion is hemi-circular with a flange, the partly-circular portion is preferably an arc of a circle from 100° to 175°, more preferably 125° to 170°, more preferably 150° to 165°, and the flange makes up the rest of the cross-section. The function of the flange is to improve the strength of the coupling between the coupling portion and the receiving portion.

Meanwhile, FIG. 4 is a cross-sectional view of the first solar cell module 1 of FIG. 1 cut along a line I-I', illustrating a detailed view of the first insertion hole 211. Referring to FIG. 4, the first insertion hole 211 formed through the second surface 204 along the first direction x of the first solar cell module 1 extends up to a receiving portion 220.

The receiving portion 220 is an area where the coupling portions 320 (see FIG. 3) inserted into the first insertion hole 211 is received, and the receiving portion 220 extends along the first direction x of the first solar cell module 1 and is bent downward at 90°.

The receiving portion 220 includes a guide portion 222 that is curved and a suspension threshold 224 formed along the third direction z of the first solar cell module 1.

The guide portion 222 allows that the first insertion hole 211 and the receiving portion 220 are formed continuously, and has the same curvature radius as the hemisphere-shape of the coupling portions 320 (see FIG. 3) and is convex in an insertion direction of the coupling portions 320.

Also, the suspension threshold 224 contacts a lower surface of the coupling portions 320 when the coupling portions 320 are received in the receiving portion 220. The suspension threshold 224 may prevent the coupling portions 320 received in the receiving portion 220 from being separated from the first solar cell module 1.

A method of connecting solar cell modules using the connecting structure will be described with reference to FIG. 5. Hereinafter, for convenience of description, an operation of coupling the coupling portions 320 will be illustrated and described.

Solar cell modules are connected using a connecting structure as follows: first, as illustrated in FIG. 5A, the coupling portion 320 is inserted into the first insertion hole 211, and then extends along the first direction x of the first solar cell module 1 so as to meet the guide portion 222.

Meanwhile, the guide portion 222 has a uniform curvature radius so as to have the same shape as the coupling portion 320, and thus, if force is continuously applied to the coupling portion 320 in the first direction x of the first solar cell module 1, as illustrated in FIG. 5B, the coupling portion 320 rotates in a direction perpendicular to the first direction x of the first solar cell module 1 along the guide portion 222 in the receiving portion 220.

The coupling portion 320 that rotates along the guide portion 222 is received in the receiving portion 220 while having a bottom surface of the coupling portion 320 being in contact with the suspension threshold 224 as illustrated in FIG. 5C. Accordingly, connection between the coupling portion 320 and the first solar cell module 1 is completed.

Meanwhile, as described above, the connection member 300 (see FIG. 3) includes the two coupling portions 320 that are connected via the connection portion 310 (see FIG. 3), and the two coupling portions 320 are simultaneously inserted into the first insertion hole 211 of the first solar cell module 1 and the second insertion hole 212 (see FIG. 1) of the second solar cell module 2 (see FIG. 1). Also, the connection portion 310 may be exposed to the outside between the first solar cell module 1 and the second solar cell module 2, and thus, the connection member 300 may be inserted into the first solar cell module 1 and the second solar cell module 2 by applying a force to the connection portion 310.

Accordingly, according to the current embodiment of the present invention, just by inserting the connection member 300 into the first insertion hole 211 and the second insertion hole 212 which are respectively formed in the first solar cell module 1 and the second solar cell module 2, the first solar cell module 1 and the second solar cell module 2 disposed adjacent may be easily connected to each other, and they may be aligned with each other.

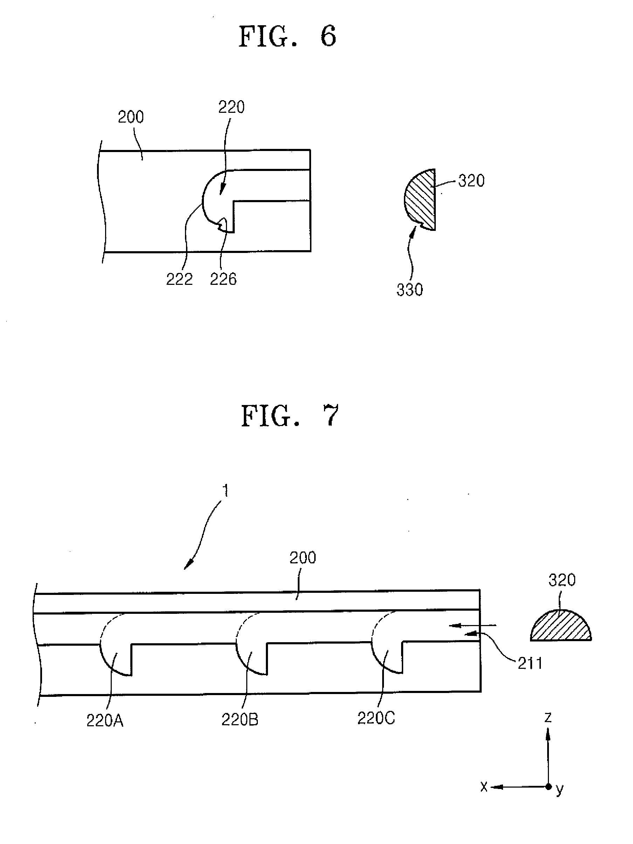

FIG. 6 is a modification example of a connecting structure of solar cell modules of FIG. 1.

Although FIG. 6 illustrates the coupling portion 320 that is received in the receiving portion 220 as illustrated in FIG. 5C, the coupling portion 320 and the receiving portion 220 are separated for convenience of description. Components such as the coupling portion 320, the receiving portion 220, the guide portion 222 or the like are the same as those illustrated in and described with reference to FIGS. 3 through 5, and description below will focus on differences from the embodiment of FIG. 5.

Referring to FIG. 6, a first connection portion 226 may be formed in the guide portion 222, and a second connection portion 330 that is coupled to the first connection portion 226 may be formed in the coupling portion 320. For example, the first connection portion 226 may be a protrusion, and the second connection portion 330 may be a groove that is matched by the protrusion.

In detail, the first connection portion 226 may be protruded in a rotation direction of the coupling portion 320 according to the guide portion 222, and may be elastic. Accordingly, the first connection portion 226 is pressed by a surface of the coupling portion 320 when the coupling portion 320 rotates while being in contact with the guide portion 222. When the coupling portion 320 is received in the receiving portion 220, the first connection portion 226 is restored to an original state by its elastic force, and is coupled to the second connection portion 330 formed in the coupling portion 320. Accordingly, when the coupling portion 320 is received in the receiving portion 220, separation of the coupling portion 320 from the frame 200 may be effectively prevented.

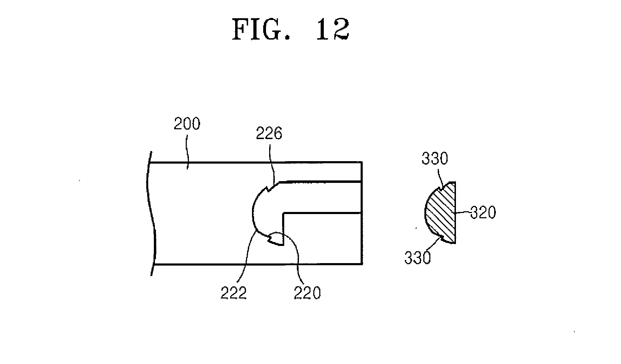

Although a single protrusion is illustrated as the first connection portion 226 in FIG. 6, the embodiment of the present invention is not limited thereto, and the first connection portion 226 may also be at least two protrusions. Also, the first connection portion 226 may be a groove, and the second connection portion 330 may be a protrusion. FIG. 12 displays an embodiment where there are two protrusions 226.

FIG, 7 is another modification example of a connecting structure of solar cell modules of FIG. 1.

FIG. 7 illustrates a state in which the coupling portion 320 is inserted into the first insertion hole 211 as illustrated in FIG. 5A. The frame 200, the coupling portion 320, and the first insertion hole 211 are the same as those as illustrated in and described with reference to FIGS. 1 through 5, and description below will focus on differences from the previous embodiments.

Referring to FIG. 7, as the first insertion hole 211 is formed in the frame 200 along the first direction x of the first solar cell module 1, the first insertion hole 211 is connected in line with first through third receiving portions 220A through 220C.

While three, the first receiving portion 220A, the second receiving portion 220B, and the third receiving portion 220C are illustrated in FIG. 7, the number of receiving portions is not limited thereto.

A plurality of connection members 300 are sequentially inserted into the first insertion hole 211, and the coupling portions 320 are respectively received in the first receiving portions 220A, the second receiving portion 220B, and the third receiving portion 220C.

Thus, a connection force between the first solar cell module 1 and the second solar cell module 2 may be further improved.

The connecting structure of solar cell modules according to the present invention is not limited to the above-described structures and methods. Some or all of the embodiments may be selectively combined to make a variety of modifications.

While the present invention has been particularly shown and described with reference to embodiments thereof, it will be understood by those of ordinary skill in the art that various changes in form and details may be made therein without departing from the scope of the present invention as defined by the following claims.

## Claims

1. A solar cell module array comprising:
a first solar cell module (1);
a second solar cell module (2); and
a connection member (300) for connecting the first solar cell module (1) to the second solar cell module (2); wherein
the first solar cell module (1) comprises a first insertion hole (211);
the second solar cell module (2) comprises a second insertion hole (212); and
the connection member (300) comprises a first coupling portion (320) adapted to be received within a receiving portion (220) of the first insertion hole (211) and a second coupling portion (320) adapted to be received within a receiving portion (220) of the second insertion hole (212), the said first and second coupling portions (320) being connected by a connection portion (310) of the connection member (300);
**characterised in that** at least one of the receiving portions (220) comprises a respective guide portion (222) having a respective concave surface, the said concave surface being curved about an axis extending substantially perpendicular to an insertion direction in which the connection member (300) may be inserted into the insertion holes (211, 212).

2. A solar cell module array according to claim 1, wherein the said concave surface is partly circular in cross-section.

3. A solar cell module array according to claim 1 or 2, wherein at least one of the coupling portions (320) comprises a respective convex surface adapted to bear against a respective said concave surface when the coupling portion (320) is received with the receiving portion (220).

4. A solar cell module array according to claim 3, wherein the said convex surface is partly circular in cross-section.

5. A solar cell module array according to claim 3 or 4, wherein the concave surface and the convex surface have the same radius

6. A solar cell module array according to any preceding claim, wherein at least one of the receiving portions (220) comprises a respective return surface (224) facing in the opposite direction to the insertion direction and adapted to act as a seat for a respective one of the coupling portions (320).

7. A solar cell module array according to any preceding claim, wherein at least one of the receiving portions (220) comprises a first locking formation (226) and at least one of the coupling portions (320) comprises a second locking formation (330), the said first and second locking formations (226, 330) being adapted to cooperate to secure the coupling portion (320) within the receiving portion (220).

8. A solar cell module array according to claim 7, wherein one of the first and second locking formations (226, 330) is a projection (226) and the other of the first and second locking formations (226, 330) is a recess (330).

9. A solar cell module array according to claim 8, wherein the first locking formation is a barb (226).

10. A solar cell module array according to any preceding claim, wherein the connection portion (310) is an elongate member.

11. A solar cell module array according to any preceding claim, wherein at least one of the insertion holes (211, 212) comprises a plurality of said receiving portions (220A, 220B, 220C) spaced from each other in the said insertion direction.

12. A solar cell module according to claim 11, comprising a plurality of said connection members (300).

13. A solar cell module array according to any preceding claim, wherein the first solar cell module (1) comprises a first solar cell unit (100) surrounded by a first frame (200) and the second solar cell module (2) comprises a second solar cell unit (100) surrounded by a second frame (200); the first insertion hole (211) being provided in the first frame (200) and the second insertion hole(212) being provided in the second frame (200).

14. A solar cell module array according to any preceding claim wherein the connection member (300) is substantially dumbbell-shaped.

15. A solar cell module according to claim 14, wherein each of the coupling portions (320) is in the form of a truncated sphere comprising a flat surface and the connection portion (310) is in the shape of a rod; the flat surfaces and the rod being coplanar.

16. A solar cell module array according to any of claims 4 to 14, wherein the partly circular cross section is substantially hemi-circular, optionally hemi-circular (320, 820, 920, 1020) or hemi-circular with a flange (1020 and 1020a).

17. A solar cell module array according to wherein coupling portion (1120) has a cross section along second direction y and third direction z of a convex pentalateral and a cross section along first direction x and third direction z of a hemi-circle.

18. A solar cell module array according to any preceding claim wherein the connection has third and fourth coupling portions.

19. A solar cell module array according to any of claims 7 to 18, wherein the coupling portion comprises two recesses (330) that correspond with two barbs (226) in the receiving portion.
